(19) **Europäisches Patentamt / European Patent Office / Office européen des brevets**

(11) **EP 3 429 213 B1**

(12) **EUROPEAN PATENT SPECIFICATION**

(45) Date of publication and mention
of the grant of the patent:
**26.04.2023 Bulletin 2023/17**

(21) Application number: **17762513.4**

(22) Date of filing: **07.03.2017**

(51) International Patent Classification (IPC):
**H04N 21/234** $^{(2011.01)}$  **H04N 19/166** $^{(2014.01)}$
**H04N 19/67** $^{(2014.01)}$  **H04N 19/89** $^{(2014.01)}$

(52) Cooperative Patent Classification (CPC):
**H03M 13/353; H03M 13/356; H04L 1/0007;
H04L 1/0009; H04L 1/0014; H04L 65/75;
H04N 7/147; H04N 7/24; H04N 19/46; H04N 19/67;
H04N 21/238; H04N 21/637;** H03M 13/1515;
H03M 13/152; H04L 1/0057; (Cont.)

(86) International application number:
**PCT/CN2017/075859**

(87) International publication number:
**WO 2017/152827 (14.09.2017 Gazette 2017/37)**

(54) **VIDEO DATA REDUNDANCY CONTROL METHOD AND APPARATUS**

VIDEODATENREDUNDANZSTEUERUNGSVERFAHREN UND -VORRICHTUNG

PROCÉDÉ ET APPAREIL DE RÉGULATION DE REDONDANCE DE DONNÉES VIDÉO

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.03.2016 CN 201610140656**

(43) Date of publication of application:
**16.01.2019 Bulletin 2019/03**

(73) Proprietor: **Tencent Technology (Shenzhen)
Company Limited
Shenzhen, Guangdong 518057 (CN)**

(72) Inventors:
• **SHI, Yongfang**
**Shenzhen, Guangdong 518057 (CN)**
• **GAO, Anlin**
**Shenzhen, Guangdong 518057 (CN)**
• **LV, Jing**
**Shenzhen, Guangdong 518057 (CN)**
• **CHEN, Jingchang**
**Shenzhen, Guangdong 518057 (CN)**
• **HE, Jian**
**Shenzhen, Guangdong 518057 (CN)**
• **GU, Chenchen**
**Shenzhen, Guangdong 518057 (CN)**

• **MAO, Xunan**
**Shenzhen, Guangdong 518057 (CN)**
• **DENG, Haibo**
**Shenzhen, Guangdong 518057 (CN)**
• **GUO, Licai**
**Shenzhen, Guangdong 518057 (CN)**
• **DAI, Chao**
**Shenzhen, Guangdong 518057 (CN)**
• **ZHANG, Xun**
**Shenzhen, Guangdong 518057 (CN)**

(74) Representative: **Gunzelmann, Rainer
Wuesthoff & Wuesthoff
Patentanwälte PartG mbB
Schweigerstraße 2
81541 München (DE)**

(56) References cited:
**EP-A1- 2 713 616    CN-A- 102 006 625
CN-A- 102 036 061    CN-A- 102 065 289
CN-A- 102 075 312    CN-A- 102 143 367
CN-A- 102 438 152    US-A1- 2010 002 692
US-A1- 2010 185 919    US-A1- 2015 169 396**

- **Q. QU ET AL: "An Adaptive Motion-Based Unequal Error Protection Approach for Real-Time Video Transport Over Wireless IP Networks", IEEE TRANSACTIONS ON MULTIMEDIA, vol. 8, no. 5, 1 October 2006 (2006-10-01) , pages 1033-1044, XP055011882, ISSN: 1520-9210, DOI: 10.1109/TMM.2006.879840**
- **LIU C-C ET AL: "PROVIDING UNEQUAL RELIABILITY FOR TRANSMITTING LAYERED VIDEO STREAMS OVER WIRELESS NETWORKS BY MULTI-ARQ SCHEMES", PROCEEDINGS 1999 INTERNATIONAL CONFERENCE ON IMAGE PROCESSING. ICIP'99. KOBE, JAPAN, OCT. 24 - 28, 1999; [INTERNATIONAL CONFERENCE ON IMAGE PROCESSING], LOS ALAMITOS, CA : IEEE, US, 24 October 1999 (1999-10-24), pages 100-104, XP000921563, ISBN: 978-0-7803-5468-5**

(52) Cooperative Patent Classification (CPC): (Cont.)
H04N 19/115; H04N 19/166; H04N 19/172;
H04N 19/188; H04N 21/6375

## Description

This application claims priority to Chinese Patent Application No. 201610140656.2, filed with the Chinese Patent Office on March 11, 2016 and titled "VIDEO DATA REDUNDANCY CONTROL METHOD AND APPARATUS".

## FIELD OF THE TECHNOLOGY

The present disclosure relates to the field of video data transmission technologies, and in particular to a video data redundancy control method and apparatus.

## BACKGROUND OF THE DISCLOSURE

Best-Effort is a standard Internet service model. For a Best-Effort data network service, a packet loss during transmission is inevitable.

In the field of video call technologies, based on characteristics of video data, a DPCM (Differential Pulse Code Modulation) coding architecture is generally used in a current mainstream video compression and coding standard. Whether each frame of the video data can be successfully decoded depends not only on data integrity of the frame, but also whether a reference frame is decoded. In such a coding architecture, an I frame (also referred to as an intra-frame coding frame) can be independently decoded without reference to any frame, a P frame (also referred to as an interframe coding frame or a forward predictive coding frame) can be successfully decoded in combination with its reference frame, and reference intra-periods of frames may be different. Therefore, the importance degree of each frame of data varies.

In the existing technology, most video data redundancy control schemes merely empirically provide more protection on front frames within I frames and I frame intra-periods, but in these schemes, redundancy protection on each frame is insufficiently refined, and their scalabilities to different code stream structures are not strong.

US2015169396A1 relates to redundant encoding, and discloses determining an available amount of bandwidth and dividing the available bandwidth by the desired redundancy level to determine the encoding required to fit the available bandwidth.

EP2713616A1 discloses applying forward error correction selectively to an encoded video sequence before it is transmitted, where error correction is adaptively applied to the more sensitive parts of a video stream, and the adaption is based on properties such as motion, error duration and frame-type, which can be applied at frame, slice or macroblock level.

## SUMMARY

The present invention is defined by the independent claims. Further aspects of the present invention are defined by the dependent claims.

Embodiments of the present disclosure provide a video data redundancy control method and apparatus, so as to implement refined redundancy protection on each frame of video data, thereby improving the transmission performance of the video data.

In some feasible implementations of the present disclosure, the receiving end feeds back the video bit rate and the redundancy level; and the sending end performs compression coding according to the video bit rate, to obtain the compressed video data; obtaining a data redundancy rate according to the redundancy level; allocates frame-level redundancy bit rate budgets for frames of the compressed video data according to the video bit rate and the data redundancy rate; and packetizes, according to an intra-period level redundancy bit rate budget and the frame-level redundancy bit rate budgets, the frames of the compressed video data, and performs redundancy coding on the packetized frames. Therefore, the redundancy control on the video data is refined to each frame, and importance of each frame may be reflected, so that redundancy control refinement of the video data is improved, thereby facilitating reducing the packet loss rate, improving the transmission performance of the video data, and facilitating improving the scalability of a code stream structure, so as to be applicable to a plurality of coding structures.

## BRIEF DESCRIPTION OF THE DRAWINGS

To describe the technical solutions in the embodiments of the present disclosure more clearly, the following briefly introduces the accompanying drawings required for describing the embodiments and the existing technology.

FIG. 1 is a schematic diagram of an HPP coding structure not claimed by the present invention;
FIG. 2 is a system architectural diagram of a redundancy control system according to an embodiment of the present disclosure not claimed by the present invention;
FIG. 3 is a schematic flowchart of a video data redundancy control method according to the invention;
FIG. 4 is a schematic flowchart of a video data redundancy control method according to another embodiment of the present disclosure not claimed by the present invention;
FIG. 5 is a schematic structural diagram of a video data redundancy control apparatus according to the invention;
FIG. 6 is a schematic structural diagram of a video data redundancy control apparatus according to another embodiment of the present disclosure not claimed by the present invention;
FIG. 7 is a schematic structural diagram of a computer device according to an embodiment of the present disclosure not claimed by the present invention; and

FIG. 8 is a schematic structural diagram of a computer device according to another embodiment of the present disclosure not claimed by the present invention.

## DESCRIPTION OF EMBODIMENTS

To make a person skilled in the art understand the solutions in the present disclosure better, the following clearly and completely describes the technical solutions in the embodiments of the present disclosure with reference to the accompanying drawings in the embodiments of the present disclosure.

As described in the background, for a Best-Effort data network service, a packet loss during transmission is inevitable. In a video call application, to improve the transmission performance, a redundancy coding control method is generally used to add a redundancy error correction packet in video data to recover a possible packet loss. For example, in a VoIP (Voice over Internet Protocol) application, to reduce a time delay, the UDP (User Datagram Protocol) protocol is generally used. To guarantee QoS (Quality of Service), generally, a possible packet loss is recovered in a manner of adding a redundancy error correction packet.

A method for adding a redundancy error correction packet in the video data may be as follows. First, each frame of the video data is packetized, so that data of each frame is divided into p data packets. Then, q redundancy error correction packets are added for the frame according to a particular redundancy coding algorithm, such as FEC (Forward Error Correction) coding, RS (Reed-solomon) coding, and Bose, BCH (Bose, Ray-Chaudhuri, and Hocquenghem) coding. Finally, the data packets and the redundancy correction packets of the frame are transmitted to a receiving end. This method may resist packet losses of q data packets. When a packet is lost, the lost data packet may be recovered by using a redundancy error correction packet. Here q and p are both positive integers. It should be noted that the packet loss resistance is determined according to the number of added redundancy error correction packets. For a frame that is important and requires more protection, relatively more redundancy error correction packets may be added.

A DPCM coding architecture is generally used in a current mainstream video compression and coding standard. In this architecture, the video data frame is classified into two types. One type is the I frame. The I frame is an intra-frame coding frame and is directly compressed and coded without reference to another frame. The other type is the P frame. The P frame is an interframe coding frame, and reference needs to be made to its reference frame, for example, an I frame before the P frame. Compression coding is performed for the difference obtained by comparing the P frame and its reference frame. Therefore, the I frame may be directly coded or decoded, while for coding or decoding of the P frame, reference needs to be made to the reference frame of the P frame. Therefore, the I frame and the P frame are different in importance. In addition, importance of different P frames may also vary. For example, assuming that a frame n is the Iframe, the frame n is a reference frame for a frame n+1 and a frame n+2, and the frame n+2 is a reference frame for a frame n+3, if decoding of the frame n+2 fails, the frame n+3 cannot be decoded. It can be learned that the frame n+1 and the frame n+2 that are both P frames are different in importance.

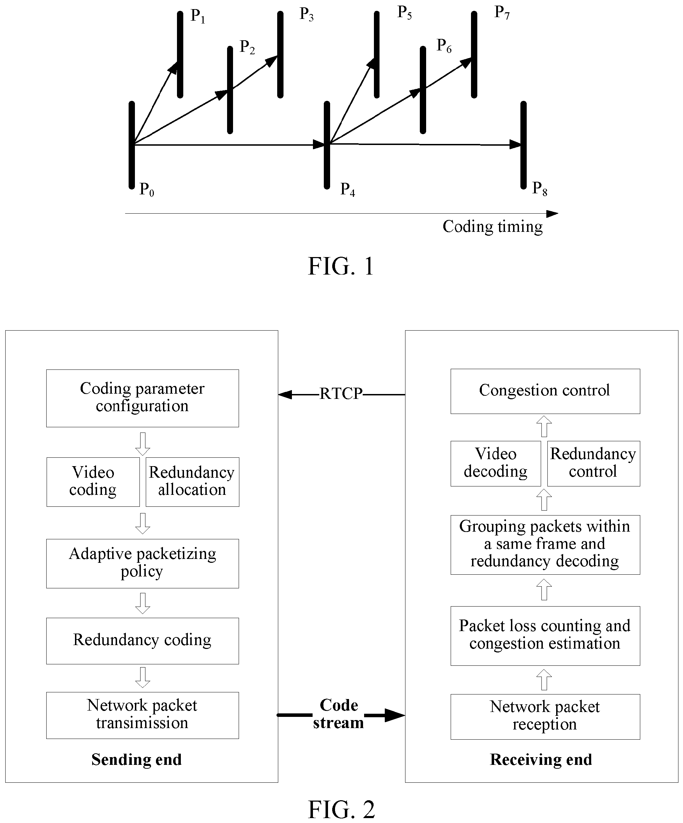

In other coding structures, the importance of frames may also vary. Referring to a HPP (Hierarchical P-frame Prediction) coding structure shown in FIG. 1, a hierarchical prediction manner is used in the HPP not claimed by the present invention. Frames at different time layers are obviously different in importance. As shown in FIG. 1, the importance of frames (P0, P4, and P8) at Layer0 is higher than the importance of frames (P2 and P6) at Layer1, and is higher still than the importance of frames (P1, P3, ... P7) at Layer2.

However, in the current video data redundancy control scheme, although an UEC (Unequal Error Protection) policy is also used to perform special protection on some important frames, but more protection is empirically provided on only front frames within I frames and I frame intra-periods. Redundancy protection cannot be respectively performed in accordance with different importance of frames, and importance of each frame cannot be quantitatively quantized; or refined frame-level redundancy protection cannot be implemented. As a result, the scalability to different code stream structures is not strong.

In addition, in terms of the video packetizing method, in the existing technology, the packet is sent based on the MTU (Maximum Transmission Unit) size as much as possible, to reduce the number of packets, thereby saving header overheads. In the packetizing method of the existing technology, large packets as close as possible to the size of the MTU are sent, and the packets may be preferentially discarded by a packet queuing policy of a route when the network is congested, resulting in insufficient packet loss resistance, and consequently, the transmission performance is reduced.

Based on the foregoing problems, to improve the packet loss resistance and improve the transmission performance of video data, embodiments of the present disclosure provide a video data redundancy control method and a corresponding apparatus.

Detailed descriptions are respectively provided below by using specific embodiments.

FIG. 2 is a system architectural diagram of a redundancy control system according to an embodiment of the present disclosure not claimed by the present invention. The redundancy control system includes a sending end and a receiving end. The sending end or the receiving end may be deployed on a terminal device such as a personal computer or a mobile communications terminal such as a smartphone or a tablet computer.

As shown in FIG. 2, in the redundancy control system in this embodiment of the present disclosure not claimed by the present invention, a working process of the sending end may include: coding parameter configuration for configuring coding parameters such as a video bit rate; video coding for performing compression coding on video data according to the configured coding parameters; redundancy allocation for allocating a redundancy bit rate for frames of compressed video data obtained by means of video coding; adaptive packetizing policy for determining a packetizing solution of each frame, for example, the number of data packets that a frame of data is divided; redundancy coding for adding a redundancy error correction packet for each frame by performing redundancy coding using an error correction coding method such as FEC; and network transmission for sending the data packets of the video data and the added redundancy error correction packets to the receiving end through a network.

A working process of the receiving end may include: network packet reception for receiving data, including the data packets of the video data and the redundancy error correction packets, sent by the sending end; packet loss counting for counting a packet loss rate, to estimate a congestion status; grouping packets within a same frame and redundancy decoding for decoding by grouping data packets and redundancy error correction packets of a same frame into one group, and when a packet is lost, recovering the lost data packet by using the redundancy error correction packet, to obtain compressed video data of each frame; video decoding for performing video decoding on the obtained compressed video data, to obtain original video data; redundancy control for determining a redundancy ratio according to a decoding status, for example, determining, according to the packet loss rate, a data redundancy rate for resisting the packet loss rate, to instruct the sending end to perform appropriate redundancy control; congestion control for determining, according to a bandwidth status, a video bit rate should be used at the sending end, and feeding back the data redundancy rate and the video bit rate back to the sending end. After receiving the data redundancy rate and the video bit rate, the sending end may configure the coding parameters according to the data redundancy rate and the video bit rate.

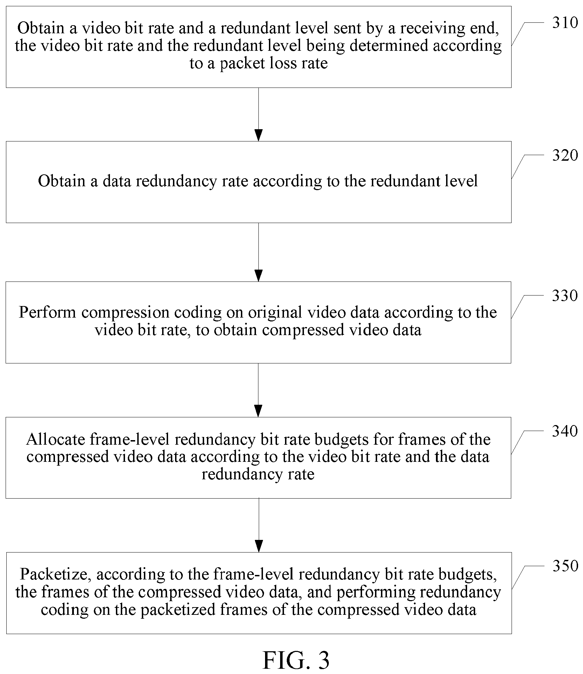

FIG. 3 illustrates the invention which provides a video data redundancy control method. The method is applied to a sending end of a redundancy control system. The method includes the following steps.

At 310, a video bit rate and a redundant level sent by a receiving end are obtained, the video bit rate and the redundant level being determined by the receiving end according to a packet loss rate.

At 320, a data redundancy rate is obtained according to the redundant level.

Optionally, a redundancy level table may be stored in both the receiving end and the sending end.

After receiving the redundancy level, the sending end may obtain, by querying the redundancy level table, the data redundancy rate corresponding to the redundancy level. The redundancy level table is used to store a correspondence between the redundancy level and the data redundancy rate.

At 330, compression coding is performed on original video data according to the video bit rate, to obtain compressed video data.

Optionally, the sending end may compress and code the original video data according to the video bit rate by using a DPCM coding scheme, to obtain the compressed video data. The compressed video data may include different types of frames such as I frames and P frames. The quantity of frames between two adjacent I frames may be referred to as an I frame intra-period. An I frame intra-period may include one I frame and a plurality of P frames.

At 340, frame-level redundancy bit rate budgets are allocated for frames of the compressed video data according to the video bit rate and the data redundancy rate.

In this step, first, an intra-period level redundancy bit rate budget may be allocated for each I frame intra-period of the compressed video data according to the video bit rate and the data redundancy rate. Then different weights may be allocated for the frames within the I frame intra-period according to the importance of the frames, and the frame-level redundancy bit rate budgets may be respectively allocated to each frame of the I frame intra-period in accordance with the allocated weights and the intra-period level redundancy bit rate budget of the I frame intra-period.

The importance of a frame is defined to be the quantity of frames that follows the frame within an intra-period but cannot be decoded because the frame fails to be decoded. Assuming that $C_i$ represents the quantity of frames that follows an $i^{th}$ frame within an intra-period but cannot be decoded when the $i^{th}$ frame fails to be decoded, a weight may be allocated for the frame according to $C_i$. The allocated weight of the $i^{th}$ frame is $\eta_i = C_i / \Sigma C_i$, where $\Sigma C_i$ is a sum of all $C_i$ within the intra-period.

$BR_v$ is the video bit rate, $r$ is the data redundancy rate, $BR_r$ is the intra-period level redundancy bit rate budget, and the intra-period level redundancy bit rate budget is calculated and allocated according to the formula

$$BR_r = BR_v * \frac{r}{1-r}.$$

$\eta_i$ is the weight of the $i^{th}$ frame within the I frame intra-period, $R_i$ is the frame-level redundancy bit rate budget of the $i^{th}$ frame, and the frame-level redundancy bit rate budget is calculated and allocated according to the formula $R_i = \eta_i * BR_r$.

In some implementations, not falling under the invention, to ensure that a key frame meets a redundancy requirement and the total bit rate does not exceed a se-

curity transmission bit rate $BR_s$, a frame-level redundancy bit rate may be corrected. Using the $i^{th}$ frame as an example, the frame-level redundancy bit rate budget $R_i$ of the $i^{th}$ frame may be corrected according to the coding size $S_i$ of the $i^{th}$ frame, to limit $R_i$ within a range $[\alpha * S_i, \beta * S_i]$, where $a$ and $\beta$ are partial redundancy coefficients, and value ranges of $a$ and $\beta$ are [0, 1].

At 350, according to the frame-level redundancy bit rate budgets, the frames of the compressed video data are packetized, and redundancy coding is performed on the packetized frames of the compressed video data.

In this embodiment of the present disclosure, after a frame of the compressed video data is packetized, redundancy coding may be performed on the frame of the compressed video data by using a coding method such as FEC coding, RS coding, or BCH coding. Different quantities of redundancy error correction packets are respectively added for different frames according to the allocated frame-level redundancy bit rate budgets, so as to implement frame-level refined redundancy protection.

In the packetizing method in the existing technology, large packets as close as possible to the size of an MTU are sent, and the packets may be preferentially discarded by a packet queuing policy of a route when the network is congested, resulting in insufficient packet loss resistance. In some embodiments of the present disclosure, the optimal packetizing parameters of the frames of the compressed video data may be calculated according to the data redundancy rate requirement, and packetizing is performed according to the optimal packetizing parameters, so as to adaptively adjust the size of the packets. Therefore, a solution having the strongest packet loss resistance with a limited redundancy bit rate budget is selected.

Using the $i^{th}$ frame as an example, a process of calculating the optimal packetizing parameters may include:

determining a range of a packet quantity of an $i^{th}$ frame of the compressed video data, where i is a positive integer;

for each packet quantity $N_j$ within the range, calculating a redundant packet quantity $M_j$ and a packet size $L_j$ corresponding to the packet quantity $N_j$ and calculating a packet-level redundancy rate $r_p$ and an over-budget deviation $\Delta$ according to the packet quantity $N_j$, where

$$r_p = \frac{M_j}{M_j + N_j}$$

, $\Delta = (N_j + M_j) * L_j - (S_i + R_i)$, $S_i$ is the coding size of the $i^{th}$ frame, and $R_i$ is the frame-level redundancy bit rate budget of the $i^{th}$ frame; and

determining, when the packet-level redundancy rate

$r_p$ is the maximum and the over-budget deviation $\Delta$ is the minimum, that the packet quantity, the packet size, and the redundant packet quantity are the optimal packetizing parameters.

In the foregoing description, with reference to FIG. 3, the invention is described by using the sending end as an execution body. In the method, the receiving end feeds back the video bit rate and the redundancy level; and the sending end performs compression coding according to the video bit rate, to obtain the compressed video data, obtains the data redundancy rate according to the redundancy level, allocates the intra-period level redundancy bit rate budget for the I frame intra-period of the compressed video data according to the video bit rate and the data redundancy rate, allocates the frame-level redundancy bit rate budgets for the frames within the I frame intra-period, and performs packetizing and redundancy coding on the compressed video data according to the intra-period level redundancy bit rate budget and the frame-level redundancy bit rate budgets. Therefore, redundancy control at the levels of the I frame intra-period and the frame are implemented, redundancy control on the video data is refined to each frame, and importance of each frame may be reflected, so that redundancy control refinement of the video data is improved, thereby facilitating reducing the packet loss rate, improving the transmission performance of the video data, and facilitating improving the scalability of a code stream structure, so as to be applicable to various coding structures.

In the following, a method according to an embodiment of the present disclosure not claimed by the present invention is described by using the receiving end as an execution body.

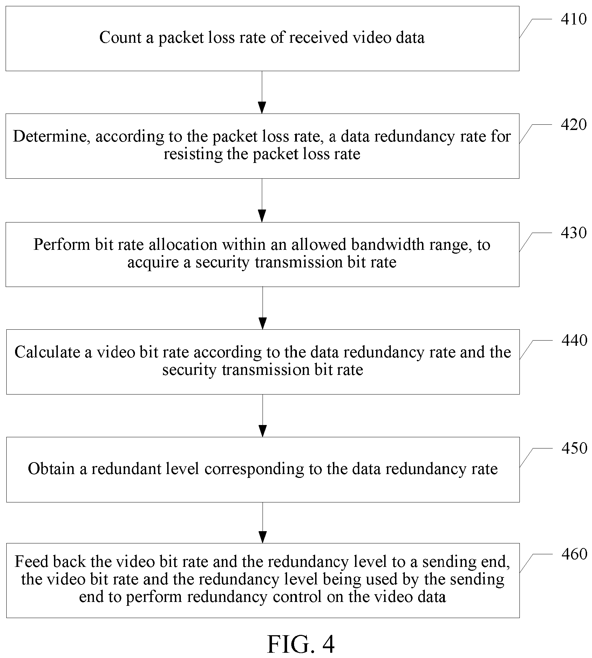

Referring to FIG. 4, an embodiment of the present disclosure not claimed by the present invention further provides a video data redundancy control method. The method is applied to a receiving end of a redundancy control system. The method may include the following steps.

At 410, a packet loss rate of received video data is counted.

In a process of receiving data packets of the video data that is sent by a sending end, the receiving end may count the packet loss rate. Herein, l is used to indicate the packet loss rate.

At 420, a data redundancy rate is determined according to the packet loss rate.

In some embodiments, the data redundancy rate may be determined according to a formula $r = k * l$, where l is the packet loss rate, k is a coefficient not greater than 3 and not less than 1, and r is the data redundancy rate. Preferably, r may be limited to be less than 1.

At 430, bit rate allocation is performed according to a bandwidth range, to acquire a security transmission bit rate.

The security transmission bit rate should not be greater than available bandwidth.

At 440, a video bit rate is calculated according to the data redundancy rate and the security transmission bit rate.

In some embodiments, the video bit rate may be calculated according to a formula $BR_v = BR_s * (1-r)$, where $BR_s$ is the security transmission bit rate, and $BR_v$ is the video bit rate.

At 450, a redundant level corresponding to the data redundancy rate is obtained.

Optionally, a redundancy level table may be stored in both the receiving end and the sending end. The receiving end may obtain, by querying the redundancy level table, a redundancy level RSLevel corresponding to the data redundancy rate r. The redundancy level table is used to store a correspondence between the redundancy level and the data redundancy rate.

At 460, the video bit rate and the redundancy level are fed back to the sending end, the video bit rate and the redundancy level being used by the sending end to perform redundancy control on the video data.

Optionally, the receiving end may feed back $BR_v$ and RSLevel to the sending end by using the RTCP (Real-Time Control Protocol) protocol.

In the foregoing description, with reference to FIG. 4, the method of the embodiment of the present disclosure is described by using the receiving end as an execution body. In the method, the receiving end determines, by counting the packet loss rate, the video bit rate and the data redundancy rate, and the redundancy level corresponding to the data redundancy rate, and feeds back the video bit rate and the redundancy level to the sending end, so that the sending end performs frame-level redundancy control on the video data. Therefore, redundancy control refinement of the video data is improved, thereby facilitating reducing the packet loss rate, improving the transmission performance of the video data, and facilitating improving the scalability of the code stream structure, so as to be applicable to various coding structures.

For ease of better understanding the technical solutions provided in the embodiments of the present disclosure, descriptions are provided below by using an implementation in a specific scenario as an example.

Another video data redundancy control method according to an embodiment of the present disclosure may include the following steps.

At S1, a sending end performs redundancy coding.

In the embodiment of the present disclosure, for a packet loss resistance redundancy coding, a particular error correction coding method having a capability of recovering a quantity of packet losses may be used, for example, FEC coding, RS coding, and BCH coding. A frame of video data obtained after compression coding may be divided into $N (N \geq 1)$ data packets, which are respectively P1, ... PN, and M redundancy data packets, respectively R1, ... RM, are added according to the foregoing particular redundancy coding algorithm, so that a code group f P1...PN, R1...RM} may resist loss of packets with the number less than M, that is, a packet loss rate

does not exceed $\dfrac{M}{M + N}$ .

At S2, a redundancy level table is configured.

To reduce the quantity of feedback data, the sending end and the receiving end may store an agreed redundancy level table. In the table, a redundancy level corresponds to a data redundancy rate $r$, to resist a particular network packet loss rate $l$.

At S3, the receiving end determines a data redundancy rate.

When the receiving end receives the packets, the packet loss rate $l$ may be counted. In the redundancy control system, the data redundancy rate $r$ that may sufficiently resist the packet loss rate may be determined according to a particular policy. The policy may be a conservative policy such as $r = l$, or a guaranteed policy such as $r = k*l$ ($k > 1$). In actual use, in consideration of balance between a network bandwidth capability limit and the packet loss resistance, $1 \leq k \leq 3$ may be stipulated.

At S4, the receiving end performs RTCP feedback.

After obtaining the data redundancy rate r, the receiving end performs bit rate allocation within an allowed bandwidth range by using a traffic congestion control function of the receiving end. Assuming that a security transmission bit rate obtained by using the congestion control function is $BR_s$ ($BR_s <= A$, where $A$ is an estimated available bandwidth), a pure video bit rate is $BR_v = BR_s * (1-r)$. In addition, the redundancy level RSLevel corresponding to the data redundancy rate $r$ may be found in the redundancy level table, and $BR_v$ and RSLevel are fed back to the sending end by using the RTCP protocol.

At S5, the sending end performs video coding and allocates a redundancy budget for an intra-period level video.

The sending end receives the RTCP feedback, and may perform compression coding by using $BR_v$ and a set of parameters associated with $BR_v$. Herein, it is assumed that the frame size of a coded $i^{th}$ frame within an intra-period is $S_i$. In addition, the sending end may find an expected data redundancy rate $r$ by using RSLevel carried in the RTCP, and a redundancy code bit budget of the intra-period is calculated according to the following formula:

$$BR_r = BR_v * \frac{r}{1-r}$$

Due to the difference of the reference relationships between frames, the importance of the frames within the intra-period varies, so that unequal error protection needs to be performed in combination with the importance of the frames. The importance of an I frame is higher than that of a P frame, for example. In an IPPP reference structure, the importance of a former frame is higher than the importance of a latter frame in GOP (Group of Pictures). In addition, in different coding structures, the importance of the frames varies. For example, in the HPP reference structure, the importance of a frame at a lower layer is higher than that of a frame at a higher layer, and in an intra-period at a lowest layer, a frame at the front is more important than a frame at the back. To quantize the importance of the frames, a weight of the $i^{th}$ frame is defined to be $\eta_i$, where $\eta_i$ is a normalized value.

The weight may be an empirical value, or may be calculated according to a particular algorithm. For example, the importance of a frame may be defined to be the quantity of frames that follows the frame within an intra-period but cannot be decoded because the frame fails to be decoded.

According to the foregoing defined weight, it may be obtained that an expected redundancy bit rate allocated to the $i^{th}$ frame is $R_i = \eta_i * BR_r$.

In addition, a video scenario may change, so that an actual coding bit rate may be not equal to the expected bit rate $BR_v$. Therefore, the redundancy rate may be corrected according to an actual coding size, so as to ensure that key frames, such as the I frames and the frame at layer0 in the HPP, meet a redundancy requirement and the total bit rate does not exceed the security transmission bit rate $BR_s$.

Specifically, using the $i^{th}$ frame as an example, $R_i$ may be limited within an interval $[\alpha*S_i, \beta*S_i]$, where $\alpha$ and $\beta$ are partial redundancy coefficients, and value ranges are [0, 1], that is, $R_i = \text{MAX}(\text{MIN}(R_i, \beta*S_i), \alpha*S_i)$.

At S6, frame-level adaptive adjustment of the size of the packets is performed.

Generally, the size of a network packet does not exceed the maximum transmission unit (MTU). In consideration of the transmission efficiency and possible impact on the audio data, the size of the video packet should not be too small. Generally, the minimum empirical value $L_{min}$ exists. The redundancy control function of the sending end can adaptively adjust the size of the packets according to a coding size of a current frame and a current redundancy bit rate budget. An overall goal is as follows:

(1) redundancy controllable, accurately adding redundancy according to a proportion; and

(2) maximizing the packet loss resistance within the redundancy budget.

After a redundancy budget $R_i$ is obtained, a packetizing manner is determined in combination with an actual coding size Si of the frame.

The algorithm is as follows.

The maximum quantity and the minimum quantity of video frames $[N_{max}, N_{min}]$ are determined according to the packet size range $[L_{min}, L_{max}]$, where

$$N_{min} = ceil(\frac{S_i}{L_{max}}), \qquad N_{max} = floor(\frac{S_i}{L_{min}}),$$

ceil is rounding up, and floor is rounding down.

All the quantity $N_j \in [N_{min}, N_{max}]$ of packets is traversed, the corresponding packet size

$$L_j = ceil(\frac{S_j}{N_j})$$

is calculated, and the quantity

$$M_j = floor((1 + \gamma) * \frac{R_j}{L_j})$$

of corresponding redundant packets is obtained, where $\gamma$ is the elastic coefficient. It is mainly considered that if the decimal portion is relatively large, the redundancy rate is reduced by rounding down. In this case, if the intra-period level redundancy budget is sufficient, a redundancy budget over the present frame within an elasticity range is allowed.

A packet-level redundancy rate $r_p$ and an actual over-budget deviation $\Delta$ for each packetizing solution are calculated:

$$r_p = \frac{M_j}{M_j + N_j}$$

$$\Delta = (N_j + M_j) * L_j - (S_i + R_i)$$

A solution in which $r_p$ is the maximum is found in all the packetizing manners, that is, a solution in which the packet loss resistance is the strongest, and optimal packetizing parameters $\{N^*, L^*, M^*\}$ are obtained. If the maximum packet-level redundancy rate $r_p$ corresponds to a plurality of packetizing solutions, the solution in which $\Delta$ is the minimum is used.

It can be learned from the above that the method of the embodiment may be applied to video data transmission such as the video call. At an intra-period level, a redundancy rate may be allocated according to the importance of each frame, and adaptive packetizing parameter adjustment may be performed according to a redundancy bit rate budget and the actual size of the video frame obtained after compression coding, to reach the maximum packet loss resistance.

In the redundancy control system according to the embodiment of the present disclosure, the receiving end reasonably determines a redundancy ratio according to a packet loss status, to be capable of resisting network packet losses at some degree. A redundancy bit rate budget is obtained according to network bandwidth estimation. In the redundancy control system, redundancy bit rate budget allocation is performed through two levels of I frame intra-period level overall control and frame-level adaptive adjustment. In terms of all frames within a video intra-period, the system provides, according to the importance of each frame, frame-level redundancy protection at a corresponding level to data obtained after compression coding, to improve the overall intra-period recovery capability. In addition, to improve the packet loss resistance of a single frame to a greatest extent within the redundancy budget, in this embodiment of the present disclosure, optimal packetizing parameters are found by using adaptive adjustment, to reach the maximum "packet-level" redundancy rate.

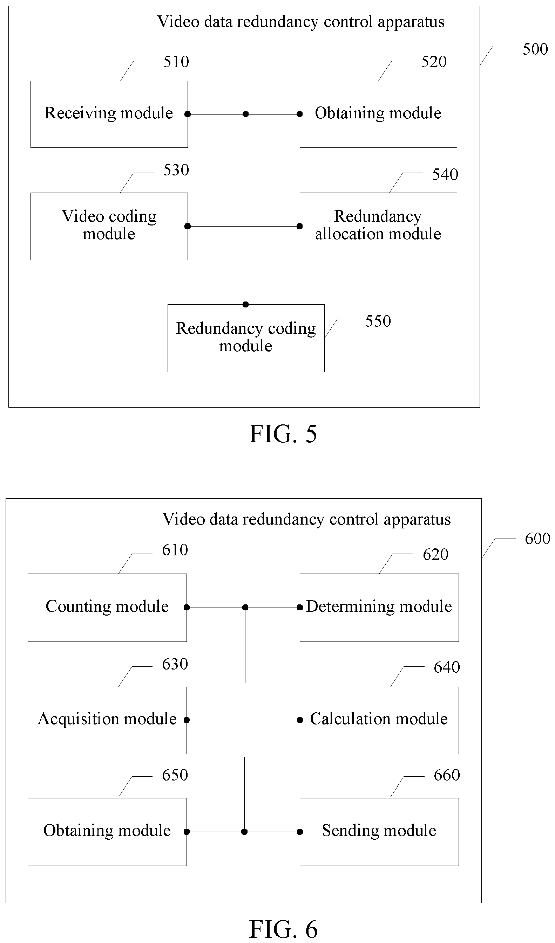

To better implement the foregoing solutions in the embodiments of the present disclosure, the following further provides related apparatuses configured to implement the foregoing solutions. FIG. 5 illustrates the invention and provides a video data redundancy control apparatus 500. The apparatus may be used at a sending end of a redundancy control system. The apparatus includes:

a receiving module 510, configured to obtain a video bit rate and a redundancy level sent by a receiving end, the video bit rate and the redundancy level being determined according to a packet loss rate;

an obtaining module 520, configured to obtain a data redundancy rate according to the redundancy level;

a video coding module 530, configured to perform compression coding on original video data according to the video bit rate, to obtain compressed video data;

a redundancy allocation module 540, configured to allocate frame-level redundancy bit rate budgets for frames of the compressed video data according to the video bit rate and the data redundancy rate; and

a redundancy coding module 550, configured to packetize, according to the frame-level redundancy bit rate budgets, the frames of the compressed video data, and perform redundancy coding on the packetized frames of the compressed video data.

In some embodiments of the present disclosure, the obtaining module 520 is specifically configured to obtain, by querying a redundancy level table, the data redundancy rate corresponding to the redundancy level, and the redundancy level table stores a correspondence between the redundancy level and the data redundancy rate.

The redundancy allocation module 540 is further configured to: allocate an intra-period level redundancy bit rate budget for an I frame intra-period of the compressed video data according to the video bit rate and the data redundancy rate; and allocate the frame-level redundancy bit rate budgets for frames within the I frame intra-period according to the intra-period level redundancy bit rate budget.

The redundancy allocation module 540 is specifically configured to allocate the intra-period level redundancy bit rate budget for the I frame intra-period of the compressed video data according to the following formula:

$$BR_r = BR_v * \frac{r}{1-r},$$

where
$BR_v$ is the video bit rate, $r$ is the data redundancy rate, and $BR_r$ is the intra-period level redundancy bit rate budget.

The redundancy allocation module 540 is specifically configured to:

allocate the frame-level redundancy bit rate budgets for the frames within the I frame intra-period according to the following formula:

$$R_i = \eta_i * BR_r$$

$\eta_i$ is a weight of an $i^{th}$ frame within the I frame intra-period, $R_i$ is the frame-level redundancy bit rate budget of the $i^{th}$ frame, and i is a positive integer.

In some embodiments of the present disclosure, not being part of the present invention, the redundancy allocation module 540 is further configured to: correct the frame-level redundancy bit rate budget $R_i$ of the $i^{th}$ frame according to a coding size $S_i$ of the $i^{th}$ frame, to limit $R_i$ within a range $[\alpha * S_i, \beta * S_i]$, where $\alpha$ and $\beta$ are partial redundancy coefficients, and value ranges of $\alpha$ and $\beta$ are [0, 1].

In some embodiments of the present disclosure, the redundancy coding module 550 is specifically configured to: calculate optimal packetizing parameters of the frames of the compressed video data according to the frame-level redundancy bit rate budgets; and perform packetizing according to the optimal packetizing parameters.

In some embodiments of the present disclosure, the redundancy coding module 550 is specifically configured to:

determine a range of a packet quantity of an $i^{th}$ frame of the compressed video data, where i is a positive integer;
for each packet quantity $N_j$ within the range, calculate, according to the coding size and the frame-level redundancy bit rate budget of the $i^{th}$ frame, a redundant packet quantity $M_j$ and a packet size $L_j$ corresponding to the packet quantity $N_j$; and calculate a packet-level redundancy rate $r_p$ and an over-budget deviation $\triangle$ according to the packet quantity $N_j$,

where

$$r_p = \frac{M_j}{M_j + N_j}$$

, $\Delta = (N_j + M_j)*L_j - (S_i + R_i)$, $S_i$ is the coding size of the $i^{th}$ frame, and $R_i$ is the frame-level redundancy bit rate budget of the $i^{th}$ frame; and determine, when the packet-level redundancy rate $r_p$ is the maximum and the over-budget deviation $\Delta$ is the minimum, that the packet quantity, the packet size, and the redundant packet quantity are the optimal packetizing parameters.

It may be understood that functions of functional modules of the apparatus in this embodiment of the present disclosure may be specifically implemented according to the method in the foregoing method embodiment. The specific implementation process of the apparatus is referred to the related description in the foregoing method embodiment. Details are not described herein again.

In the foregoing description, with reference to FIG. 5 the invention provides a video data redundancy control apparatus used at the sending end. The apparatus may obtain the video bit rate and the redundancy level that are fed back by the receiving end; perform compression coding according to the video bit rate, to obtain compressed video data; obtain the data redundancy rate according to the redundancy level; allocate an intra-period level redundancy bit rate budget for the I frame intra-period of the compressed video data according to the video bit rate and the data redundancy rate; allocate the frame-level redundancy bit rate budgets for the frames within the I frame intra-period; and perform packetizing and redundancy coding on the compressed video data according to the intra-period level redundancy bit rate budget and the frame-level redundancy bit rate budgets. Therefore, redundancy control at the levels of the I frame intra-period and the frame are implemented, redundancy control on video data is refined to each frame, and importance of each frame may be reflected, so that redundancy control refinement of the video data is improved, thereby facilitating reducing the packet loss rate, improving the transmission performance of the video data, and facilitating improving the scalability of the code stream structure, so as to be applicable to various coding structures.

Referring to FIG. 6, an embodiment of the present disclosure not claimed by the present invention provides a video data redundancy control apparatus 600. The apparatus may be used at a receiving end of a redundancy control system. The apparatus may include:

a counting module 610, configured to count a packet loss rate of received video data;
a determining module 620, configured to determine a data redundancy rate according to the packet loss rate;

an acquisition module 630, configured to perform bit rate allocation according to a bandwidth range, to acquire a security transmission bit rate;
a calculation module 640, configured to calculate a video bit rate according to the data redundancy rate and the security transmission bit rate;
an obtaining module 650, configured to obtain a redundancy level corresponding to the data redundancy rate; and
a sending module 660, configured to send the video bit rate and the redundancy level to a sending end, the video bit rate and the redundancy level being used by the sending end to perform redundancy control on the video data.

In an embodiment of the present disclosure, the determining module 620 is specifically configured to: determine the data redundancy rate according to a formula $r = k*l$, where l is the packet loss rate, k is a coefficient not greater than 3 and not less than 1, r is the data redundancy rate, and preferably, r may be limited to be less than 1.

In an embodiment of the present disclosure, the calculation module 640 is specifically configured to: calculate the video bit rate according to a formula $BR_v = BR_s *(1-r)$, where $BR_s$ is the security transmission bit rate, and $BR_v$ is the video bit rate.

It may be understood that functions of functional modules of the apparatus in this embodiment of the present disclosure may be specifically implemented according to the method in the foregoing method embodiment. The specific implementation process of the apparatus is referred to the related description in the foregoing method embodiment. Details are not described herein again.

In the foregoing description, with reference to FIG. 6, this embodiment of the present disclosure not claimed by the present invention provides a video data redundancy control apparatus used at the receiving end. The apparatus may determine, by counting the packet loss rate, the video bit rate and the data redundancy rate, as well as the redundancy level corresponding to the data redundancy rate; and feed back the data redundancy rate and the redundancy level to the sending end, so that the sending end performs frame-level redundancy control on the video data. Therefore, redundancy control refinement of the video data is improved, thereby facilitating reducing the packet loss rate, improving the transmission performance of the video data, and facilitating improving the scalability of the code stream structure, so as to be applicable to various coding structures.

An embodiment of the present disclosure not claimed by the present invention further provides a computer storage medium. The computer storage medium may store a program. When being executed, the program performs some or all of the steps of the video data redundancy control method in the method embodiment shown in FIG. 3, or performs some or all of the steps of the video data redundancy control method in the method embodiment shown in FIG. 4. When the program stored in the computer storage medium is executed by a computer device including one or more processors, it configures the computer device to perform the video data redundancy control method in the method embodiment shown in FIG. 3, or performs the video data redundancy control method in the method embodiment shown in FIG. 4.

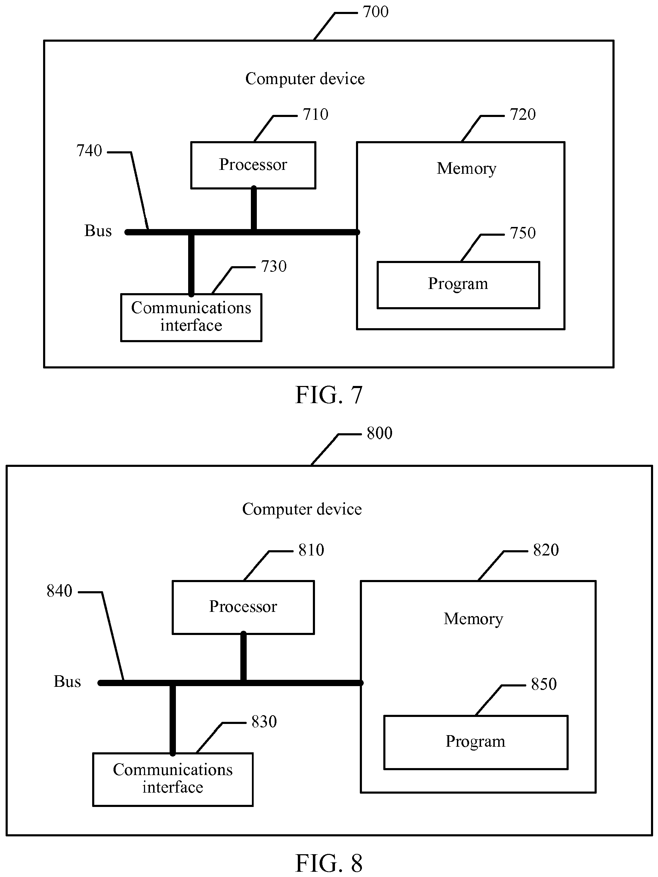

Referring to FIG. 7, an embodiment of the present disclosure not claimed by the present invention further provides a computer device 700, including:
a processor 710, a memory 720, a communications interface 730, and a bus 740.

The memory 720 is configured to store a program 750, and the processor 710 is connected to the memory 720 via the bus 740. When the computer device 700 runs, the processor 710 executes the program 750 stored in the memory 720, so that the computer device 700 performs the video data redundancy control method in the method embodiment shown in FIG. 3.

The communications interface 730 is configured to perform the following step: obtaining a video bit rate and a redundancy level that are fed back by a receiving end, the video bit rate and the redundancy level being calculated by the receiving end according to the packet loss rate.

The processor 710 is configured to perform the following steps: obtaining a data redundancy rate according to the redundancy level; performing compression coding on original video data according to the video bit rate, to obtain compressed video data; allocating frame-level redundancy bit rate budgets for frames of the compressed video data according to the video bit rate and the data redundancy rate; and packetizing, according to the frame-level redundancy bit rate budgets, the frames of the compressed video data, and performing redundancy coding on the packetized frames of the compressed video data.

Optionally, the processor 710 is further configured to perform the following step: obtaining, by querying a redundancy level table, the data redundancy rate corresponding to the redundancy level, the redundancy level table storing a correspondence between the redundancy level and the data redundancy rate.

Optionally, the processor 710 is further configured to perform the following steps: allocating an intra-period level redundancy bit rate budget for an I frame intra-period of the compressed video data according to the video bit rate and the data redundancy rate; and allocating the frame-level redundancy bit rate budgets for frames within the I frame intra-period according to the intra-period level redundancy bit rate budget.

Optionally, the processor 710 is further configured to perform the following step:

allocating the intra-period level redundancy bit rate budget for the I frame intra-period of the compressed video data according to the following formula:

$$BR_r = BR_v * \frac{r}{1-r},$$

where

$BR_v$ is the video bit rate, $r$ is the data redundancy rate, and $BR_r$ is the intra-period level redundancy bit rate budget.

Optionally, the processor 710 is further configured to perform the following step:

allocating the frame-level redundancy bit rate budgets for the frames within the I frame intra-period according to the following formula:

$$R_i = \eta_i * BR_r,$$

where

$\eta_i$ is a weight of an ith frame within the I frame intra-period, $R_i$ is the frame-level redundancy bit rate budget of the ith frame, i being a positive integer.

Optionally, the processor 710 is further configured to perform the following step:
correcting the frame-level redundancy bit rate budget $R_i$ of the ith frame according to a coding size $S_i$ of the ith frame, to limit $R_i$ within a range $[\alpha^* S_i, \beta^* S_i]$, where $\alpha$ and $\beta$ are partial redundancy coefficients, and value ranges of $\alpha$ and $\beta$ are [0, 1].

Optionally, the processor 710 further performs the following steps: calculating optimal packetizing parameters of the frames of the compressed video data according to the frame-level redundancy bit rate budgets; and performing packetizing according to the optimal packetizing parameters.

Optionally, the processor 710 is further configured to perform the following steps:

determining a range of a packet quantity of an ith frame of the compressed video data, where i is a positive integer;

for each packet quantity $N_j$ within the range, calculating a redundant packet quantity $M_j$ and a packet size $L_j$ corresponding to the packet quantity $N_j$; and calculating a packet-level redundancy rate $r_p$ and an over-budget deviation $\Delta$ according to the packet quantity $N_j$, where

$$r_p = \frac{M_j}{M_j + N_j}$$
$\Delta = (N_j + M_j)^* L_j - (S_i + R_i)$, $S_i$ is

the coding size of the $i^{th}$ frame, and $R_i$ is the frame-level redundancy bit rate budget of the $i^{th}$ frame; and

determining, when the packet-level redundancy rate $r_p$ is the maximum and the over-budget deviation $\Delta$ is the minimum, that the packet quantity, the packet size, and the redundant packet quantity are the optimal packetizing parameters.

The bus 740 may be an industry standard architecture (ISA) bus, a peripheral component interconnect (PCI) bus, an extended industry standard architecture (EISA) bus, or the like. The bus may include one or more of an address bus, a data bus, and a control bus. For ease of representation, only one bold line is used to represent the bus in the figure, but this does not mean that there is only one bus or only one type of bus.

The memory 720 may include a high-speed random access memory (RAM). Optionally, the memory 720 may further include a non-volatile memory. For example, the memory 720 may include a magnetic disk memory.

The processor 710 may be a central processing unit (CPU), or the processor 710 may be an application-specific integrated circuit (ASIC), or the processor 710 may be one or more integrated circuits configured to implement the embodiments of the present disclosure.

It may be understood that, functions of the functional modules of the computer device in the embodiment of the present disclosure may be specifically implemented according to the methods in the foregoing method embodiments. The specific implementation processes is referred to related descriptions in the foregoing method embodiments, and details are not described herein again.

The computer device disclosed in this embodiment of the present disclosure may perform the video data redundancy control method according to the foregoing method embodiments, and obtain the technical effects that the foregoing method embodiments can be obtained.

Referring to FIG. 8, an embodiment of the present disclosure not claimed by the present invention further provides a computer device 800, including:
a processor 810, a memory 820, a communications interface 830, and a bus 840.

The memory 820 is configured to store a program 850, and the processor 810 is connected to the memory 820 via the bus 840. When the computer device 800 runs, the processor 810 executes the program 850 stored in the memory 820, so that the computer device 800 performs the video data redundancy control method in the method embodiment shown in FIG. 4.

The processor 810 is configured to perform the following steps: counting a packet loss rate of received video data; determining, according to the packet loss rate, a data redundancy rate used for resisting the packet loss rate; performing bit rate allocation within an allowed bandwidth range, to acquire a security transmission bit rate; calculating a video bit rate according to the data redundancy rate and the security transmission bit rate; and obtaining a redundancy level corresponding to the data redundancy rate.

The communications interface 830 is configured to perform the following steps: sending the video bit rate and the redundancy level to a sending end, the video bit rate and the redundancy level being used by the sending end to perform redundancy control on the video data.

Optionally, the processor 810 is further configured to perform the following step: determining the data redundancy rate according to a formula $r = k * l$, where l is the packet loss rate, k is a coefficient not greater than 3 and not less than 1, and r is the data redundancy rate. Preferably, r may be limited to be less than 1.

Optionally, the processor 810 is further configured to perform the following step: calculating the video bit rate according to a formula $BR_v = BR_s * (1-r)$, where $BR_s$ is the security transmission bit rate, and $BR_v$ is the video bit rate.

The bus 840 may be an industry standard architecture (ISA) bus, a peripheral component interconnect (PCI) bus, an extended industry standard architecture (EISA) bus, or the like. The bus may include one or more of an address bus, a data bus, and a control bus. For ease of representation, only one bold line is used to represent the bus in the figure, but this does not mean that there is only one bus or only one type of bus.

The memory 820 may include a high-speed random access memory (RAM). Optionally, the memory 820 may further include a non-volatile memory. For example, the memory 820 may include a magnetic disk memory.

The processor 810 may be a central processing unit CPU), or the processor 810 may be an application-specific integrated circuit (ASIC), or the processor 810 may be one or more integrated circuits configured to implement the embodiments of the present disclosure.

It may be understood that, functions of the functional modules of the computer device in the embodiment of the present disclosure may be specifically implemented according to the methods in the foregoing method embodiments. The specific implementation processes is referred to related descriptions in the foregoing method embodiments, and details are not described herein again.

The computer device disclosed in this embodiment of the present disclosure may perform the video data redundancy control method according to the foregoing method embodiments, and obtain the technical effects that the foregoing method embodiments can be obtained.

In the foregoing embodiments, the description of each embodiment has respective focuses. For a part that is not described in detail in an embodiment, it may refer to related descriptions in other embodiments.

**Claims**

1. A video data redundancy control method applied to a sending end, comprising:

   obtaining (310) a video bit rate and a redundancy level sent by a receiving end;
   obtaining (320) a data redundancy rate according to the redundancy level;
   performing (330) compression coding on original video data according to the video bit rate, to obtain compressed video data;
   allocating (340) frame-level redundancy bit rate budgets for frames of the compressed video data according to the video bit rate and the data redundancy rate; and
   packetizing, according to the frame-level redundancy bit rate budgets, the frames of the compressed video data, and performing redundancy coding on the packetized frames of the compressed video data, wherein
   the allocating the frame-level redundancy bit rate budgets for the frames of the compressed video data comprises:

      allocating an intra-period level redundancy bit rate budget for an I frame intra-period of the compressed video data according to the video bit rate and the data redundancy rate, the I frame intra-period comprising one I frame and a plurality of P frames; and
      allocating the frame-level redundancy bit rate budgets for frames within the I frame intra-period according to the intra-period level redundancy bit rate budget, wherein the allocating the intra-period level redundancy bit rate budget for the I frame intra-period of the compressed video data comprises:

         allocating the intra-period level redundancy bit rate budget for the I frame intra-period of the compressed video data according to the following formula:

$$BR_r = BR_v * \frac{r}{1-r},$$

         wherein
         $BR_v$ is the video bit rate, $r$ is the data redundancy rate which is less than 1, and $BR_r$ is the intra-period level redundancy bit rate budget, wherein the allocating the frame-level redundancy bit rate budgets for the frames within the I frame intra-period according to the intra-period level redundancy bit rate budget comprises:

      allocating the frame-level redundancy bit rate budgets for the frames within the I frame intra-period according to the following formula:

$$R_i = \eta_i * BR_r,$$

      wherein
      $\eta_i$ is a weight of an $i^{th}$ frame within the I frame intra-period, $R_i$ is the frame-level redundancy bit rate budget of the $i^{th}$ frame, i being a positive integer, wherein
      $C_i$ represents a quantity of frames that follows an $i^{th}$ frame within an intra-period but cannot be decoded when the $i^{th}$ frame fails to be decoded, a weight is allocated for the frame according to $C_i$, and the allocated weight of the $i^{th}$ frame is $\eta_i = C_i/\Sigma C_i$, where $\Sigma C_i$ is a sum of all $C_i$ within the intra-period.

2. The method according to claim 1, wherein the obtaining the data redundancy rate according to the redundancy level comprises:
   obtaining, by querying a redundancy level table, the data redundancy rate corresponding to the redundancy level, the redundancy level table storing a correspondence between the redundancy level and the data redundancy rate.

3. A video data redundancy control apparatus (500) used at a sending end, comprising:

   a receiving module (510), configured to obtain a video bit rate and a redundancy level sent by a receiving end;
   an obtaining module (520), configured to obtain a data redundancy rate according to the redundancy level;
   a video coding module (530), configured to perform compression coding on original video data according to the video bit rate, to obtain compressed video data;
   a redundancy allocation module (540), configured to allocate frame-level redundancy bit rate budgets for frames of the compressed video data according to the video bit rate and the data redundancy rate; and
   a redundancy coding module (550), configured to packetize, according to the frame-level redundancy bit rate budgets, the frames of the compressed video data, and perform redundancy coding on the packetized frames of the compressed video data, wherein
the redundancy allocation module (540) is further configured to:

allocate an intra-period level redundancy bit rate budget for an I frame intra-period of the compressed video data according to the video bit rate and the data redundancy rate, the I frame intra-period comprising one I frame and a plurality of P frames; and allocate the frame-level redundancy bit rate budgets for frames within the I frame intra-period according to the intra-period level redundancy bit rate budget, wherein the redundancy allocation module (540) is specifically configured to allocate the intra-period level redundancy bit rate budget for the I frame intra-period of the compressed video data according to the following formula:

$$BR_r = BR_v * \frac{r}{1-r},$$

wherein
$BR_v$ is the video bit rate, $r$ is the data redundancy rate which is less than 1, and $BR_r$ is the intra-period level redundancy bit rate budget, wherein
the redundancy allocation module (540) is specifically configured to allocate the frame-level redundancy bit rate budgets for the frames within the I frame intra-period according to the following formula:

$$R_i = \eta_i * BR_r,$$

wherein
$\eta_i$ is a weight of an $i^{th}$ frame within the I frame intra-period, $R_i$ is the frame-level redundancy bit rate budget of the $i^{th}$ frame, and i is a positive integer, wherein
$C_i$ represents a quantity of frames that follows an $i^{th}$ frame within an intra-period but cannot be decoded when the $i^{th}$ frame fails to be decoded, a weight is allocated for the frame according to $C_i$, and the allocated weight of the $i^{th}$ frame is $\eta_i = C_i/\Sigma C_i$, where $\Sigma C_i$ is a sum of all $C_i$ within the intra-period.

4. The apparatus (500) according to claim 3, wherein the obtaining module (520) is further configured to obtain, by querying a redundancy level table, the data redundancy rate corresponding to the redundancy level, the redundancy level table storing a correspondence between the redundancy level and the data redundancy rate.

**Patentansprüche**

1. Verfahren zur Steuerung einer Redundanz von Videodaten, angewandt auf ein Sendeseite, umfassend:

Erhalten (310) einer Videobitrate und eines Redundanzniveaus, die von einer Empfangsseite gesendet werden;
Erhalten (320) einer Datenredundanzrate entsprechend dem Redundanzniveau;
Ausführen (330) von Komprimierungskodierung auf ursprüngliche Videodaten entsprechend der Videobitrate, um komprimierte Videodaten zu erhalten;
Zuweisen (340) von Budgets für Redundanz-Bitraten auf Rahmenebene für Rahmen der komprimierten Videodaten gemäß der Videobitrate und der Datenredundanzrate; und
Paketieren der Rahmen der komprimierten Videodaten gemäß dem Budget für die Redundanzbitrate auf Rahmenebene, und Durchführen einer Redundanzkodierung an den paketierten Rahmen der komprimierten Videodaten, wobei
die Zuweisung der Budgets für Redundanzbitraten auf Rahmenebene für die Rahmen der komprimierten Videodaten umfasst:

Zuweisen eines Redundanzbitratenbudgets auf Intraperiodenebene für eine I-Rahmen-Intraperiode der komprimierten Videodaten gemäß der Videobitrate und der Datenredundanzrate, wobei die I-Rahmen-Intraperiode einen I-Rahmen und eine Vielzahl von P-Rahmen umfasst; und
Zuweisen der Redundanzbitratenbudgets auf Rahmenebene für Rahmen innerhalb der I-Rahmen-Intra-Periode gemäß dem Redundanzbitratenbudget auf Intra-Periodenebene, wobei
die Zuweisung des Redundanzbitratenbudgets auf Intraperiodenebene für die I-Rahmen-Intraperiode der komprimierten Videodaten umfasst:

Zuweisen des Redundanz-Bitratenbudgets auf Intra-Perioden-Ebene für die Intra-Periode von I Rahmen der komprimierten Videodaten gemäß der folgenden Formel:

$$BR_r = BR_v * \frac{r}{1-r},$$

wobei
$BR_v$ die Videobitrate ist, $r$ die Datenredundanzrate ist, die kleiner als 1 ist, und $BR_r$ das Budget für die Redundanzbitrate innerhalb einer Periode ist, wobei das Zuweisen der Rahmenebene-Redundanzbitratenbudgets für die Rahmen innerhalb der I-Rahmen-Intra-Periode gemäß dem Intra-Periodenebene-Redundanzbitratenbudget umfasst:

Zuweisen der Redundanz-Bitratenbudgets auf Rahmenebene für die Rahmen innerhalb der I-Rahmen-Intra-Periode gemäß der folgenden Formel:

$$R_i = \eta_i * BR_r \text{,}$$

wobei
$\eta_i$ eine Gewichtung eines $i^{ten}$ Rahmens innerhalb der I Rahmen-Intra-Periode ist, $R_i$ das Redundanz-Bitratenbudget auf Rahmenebene des $i^{ten}$ Rahmens ist, wobei i eine positive ganze Zahl ist, wobei $C_i$ eine Menge von Rahmen darstellt, die auf einen $i^{ten}$ Rahmen innerhalb einer Intra-Periode folgt, aber nicht dekodiert werden kann, wenn der $i^{te}$ Rahmen nicht dekodiert werden kann, wird dem Rahmen ein Gewicht gemäß $C_i$ zugewiesen, und das zugewiesene Gewicht des $i^{ten}$ Rahmens $\eta_i = C_i/\Sigma C_i$, wobei $\Sigma C_i$ eine Summe aller $C_i$ innerhalb der Intra-Periode ist.

2. Verfahren nach Anspruch 1, wobei das Ermitteln der Datenredundanzrate entsprechend dem Redundanzniveau umfasst:
Erhalten der Datenredundanzrate, die dem Redundanzniveau entspricht, durch Abfrage einer Redundanzniveautabelle, wobei die Redundanzniveautabelle eine Entsprechung zwischen dem Redundanzniveau und der Datenredundanzrate speichert.

3. Videodaten-Redundanz-Steuerungsvorrichtung (500), die an einer Sendeseite angewendet wird, umfassend:

ein Empfangsmodul (510), das so konfiguriert ist, dass es eine Videobitrate und ein Redundanzniveau erhält, die von einer Empfangsseite gesendet werden;
ein Erfassungsmodul (520), das so konfiguriert ist, dass es eine Datenredundanzrate entsprechend dem Redundanzniveau erhält;
ein Videocodierungsmodul (530), das so konfiguriert ist, dass es eine Kompressionscodierung an Originalvideodaten entsprechend der Videobitrate durchführt, um komprimierte Videodaten zu erhalten;
ein Redundanzzuweisungsmodul (540), das so konfiguriert ist, dass es Budgets für Redundanzbitraten auf Rahmenebene für Rahmen der komprimierten Videodaten gemäß der Videobitrate und der Datenredundanzrate zuweist; und
ein Redundanzkodierungsmodul (550), das so konfiguriert ist, dass es die Rahmen der komprimierten Videodaten entsprechend den Budgets für die Redundanzbitrate auf Rahmenebene paketiert und eine Redundanzcodierung an den paketierten Rahmen der komprimierten Videodaten durchführt, wobei das Redundanzzuweisungsmodul (540) ferner konfiguriert ist zum:

Zuweisen eines Intra-Perioden-Level-Redundanzbitratenbudgets für eine I-Rahmen-Intra-Periode der komprimierten Videodaten gemäß der Videobitrate und der Datenredundanzrate, wobei die I-Rahmen-Intra-Periode einen I-Rahmen und eine Vielzahl von P-Rahmen umfasst; und
Zuweisen der Rahmenebene-Redundanzbitratenbudgets für Rahmen innerhalb der I-Rahmen-Intra-Periode gemäß dem Intra-Periodenebene-Redundanzbitratenbudget, wobei das Redundanzzuweisungsmodul (540) speziell konfiguriert ist, um das Intra-Periodenebene-Redundanzbitratenbudget für die I-Rahmen-Intra-Periode der komprimierten Videodaten gemäß der folgenden Formel zuzuweisen:

$$BR_r = BR_v * \frac{r}{1-r} \text{,}$$

wobei
$BR_v$ die Videobitrate ist, $r$ die Datenredundanzrate ist, die kleiner als 1 ist, und $BR_r$ das Budget für die Redundanzbitrate innerhalb einer Periode ist, wobei das Redundanzzuweisungsmodul (540) speziell konfiguriert ist, um die Redundanzbitratenbudgets auf Rahmenebene für die Rahmen innerhalb der I-Rahmen-Intra-Periode gemäß der folgenden Formel zuzuweisen:

$$R_i = \eta_i * BR_r \text{,}$$

wobei

$\eta_i$ ein Gewicht eines $i^{ten}$ Rahmens innerhalb der Intra-Periode des Rahmens I ist, $R_i$ das Redundanz-Bitratenbudget auf Rahmenebene des $i^{ten}$ Rahmens ist und i eine positive ganze Zahl ist, wobei
$C_i$ eine Menge von Rahmen darstellt, die auf einen $i^{ten}$ Rahmen innerhalb einer Intra-Periode folgt, aber nicht dekodiert werden kann, wenn der $i^{te}$ Rahmen nicht dekodiert werden kann, wird dem Rahmen ein Gewicht gemäß $C_i$ zugewiesen, und das zugewiesene Gewicht des $i^{ten}$ Rahmen $\eta_i$ = $C_i/\Sigma C_i$, wobei $\Sigma C_i$ eine Summe aller $C_i$ innerhalb der Intra-Periode ist.

4. Vorrichtung (500) nach Anspruch 3, wobei das Erfassungsmodul (520) ferner so konfiguriert ist, dass es durch Abfrage einer Redundanzniveautabelle die dem Redundanzniveau entsprechende Datenredundanzrate erhält, wobei die Redundanzniveautabelle eine Entsprechung zwischen dem Redundanzniveau und der Datenredundanzrate speichert.

**Revendications**

1. Procédé de régulation de redondance de données vidéo appliqué à une extrémité d'envoi, consistant à:

obtenir (310) un débit binaire de vidéo et un niveau de redondance envoyés par une extrémité de réception;
obtenir (320) un taux de redondance de données selon le niveau de redondance;
effectuer (330) un codage de compression sur des données vidéo originales selon le débit binaire de vidéo pour obtenir des données vidéo comprimées;
allouer (340) des budgets de débit binaire de redondance au niveau de l'image pour des images des données vidéo comprimées conformément au débit binaire de vidéo et au taux de redondance de données; et
mettre en paquets, conformément aux budgets de débit binaire de redondance au niveau de l'image, les images des données vidéo comprimées, et effectuer un codage de redondance sur les images regroupées des données vidéo comprimées, dans lequel
l'allocation des budgets de débit binaire de redondance au niveau de l'image pour les images des données vidéo comprimées consiste à:

allouer un débit binaire de redondance au niveau de période intra pour une période intra d'image I des données vidéo comprimées conformément au débit binaire vidéo et au taux de redondance de données, la période intra d'image I comprenant une image I et une pluralité d'images P; et
allouer les budgets de débit binaire de redondance au niveau de l'image pour les images dans la période intra d'image I conformément au budget de débit binaire de redondance au niveau de la période intra, dans lequel
l'allocation du budget de débit binaire de redondance au niveau de la période intra pour la période intra d'image I des données vidéo comprimées consiste à:

allouer le budget de débit binaire de redondance au niveau de la période intra pour la période intra d'image I des données vidéo comprimées conformément à la formule suivante:

$$BR_r = BR_v * \frac{r}{1-r},$$

où
$BR_v$ est le débit binaire vidéo, r est le taux de redondance de données qui est inférieur à 1, et $BR_r$ est le budget de débit binaire de redondance au niveau de la période intra, dans lequel
l'allocation des budgets de débit binaire de redondance au niveau de l'image pour les images dans la période intra d'image I conformément au budget de débit binaire de redondance au niveau de la période intra consiste à:

allouer les budgets de débit binaire de redondance au niveau de l'image pour les images dans la période intra d'image I conformément à la formule suivante:

$$R_i = \eta_i * BR_r,$$

où
$\eta_i$ est un poids d'une $i^{ème}$ image dans la période intra d'image I, $R_i$ est le budget de débit binaire au niveau de l'image de la $i^{ème}$ image, i étant un nombre entier positif, dans lequel
$C_i$ représente une quantité d'images qui suivent une $i^{ème}$ image dans une période intra mais ne peuvent pas être codées lorsque la $i^{ème}$ image ne parvient pas à être codée, un poids est alloué à l'image conformément à $C_i$, et le poids alloué de la $i^{ème}$ image est $\eta_i = C_i/\Sigma C_i$, où $\Sigma C_i$ est une somme de tous les $C_i$ dans la période intra.

2. Procédé selon la revendication 1, dans lequel l'obtention du taux de redondance de données conformément au niveau de redondance consiste à : obtenir, par interrogation d'une table de niveaux de redondance, le taux de redondance de données correspondant au niveau de redondance, la table de niveaux de redondance stockant une correspondance entre le niveau de redondance et le taux de redondance de données.

3. Appareil de régulation de redondance de données vidéo (500) utilisé à une extrémité d'envoi, comprenant :

un module de réception (510), configuré pour obtenir un débit binaire de vidéo et un niveau de redondance envoyés par une extrémité de réception ;
un module d'obtention (520), configuré pour obtenir un taux de redondance de données selon le niveau de redondance ;
un module de codage vidéo (530), configuré pour effectuer un codage de compression sur des données vidéo originales conformément au taux binaire de vidéo, pour obtenir des données vidéo comprimées ;
un module d'allocation de redondance (540), configuré pour allouer des budgets de débit binaire de redondance au niveau de l'image pour des images des données vidéo comprimées conformément au débit binaire de vidéo et au taux de redondance de données ; et
un module de codage de redondance (550), configuré pour mettre en paquets, conformément aux budgets de débit binaire de redondance au niveau de l'image, les images des données vidéo comprimées, et effectuer un codage de redondance sur les images mises en paquets des données vidéo comprimées, dans lequel le module d'allocation de redondance (540) est en outre configuré pour :

allouer un débit binaire de redondance au niveau de période intra pour une période intra d'image I des données vidéo comprimées conformément au débit binaire vidéo et au taux de redondance de données, la période intra d'image I comprenant une image I et une pluralité d'images P ; et
allouer les budgets de débit binaire de redondance au niveau de l'image pour les images dans la période intra d'image I conformément au budget de débit binaire de redondance au niveau de la période intra, dans lequel le module d'allocation de redondance (540) est configuré en particulier pour allouer le budget de débit binaire de redondance au niveau de la période intra pour la période intra d'image I des données vidéo comprimées conformément à la formule suivante :

$$BR_r = BR_v * \frac{r}{1-r},$$

où
$BR_v$ est le débit binaire vidéo, r est le taux de redondance de données qui est inférieur à 1, et $BR_r$ est le budget de débit binaire de redondance au niveau de la période intra, dans lequel
le module d'allocation de redondance (540) est en particulier configuré pour allouer les budgets de débit binaire de redondance au niveau de l'image pour les images dans la période intra d'image I conformément à la formule suivante :

$$R_i = \eta_i * BR_r,$$

où
$\eta_i$ est un poids d'une $i^{ème}$ image dans la période intra d'image I, $R_i$ est le budget de débit binaire au niveau de l'image de la $i^{ème}$ image et i est un nombre entier positif, dans lequel
$C_i$ représente une quantité d'images qui suivent une $i^{ème}$ image dans une période intra mais ne peut pas être codées lorsque la $i^{ème}$ image ne parvient pas à être codée, un poids est alloué à l'image conformément à $C_i$, et le poids alloué de la $i^{ème}$ image est $\eta_i = C_i/\Sigma C_i$, où $\Sigma C_i$ est une somme de tous les $C_i$ dans la période intra.

4. Appareil (500) selon la revendication 3, dans lequel le module d'obtention (520) est en outre configuré pour obtenir, par interrogation d'une table de niveaux de redondance, le taux de redondance de données correspondant au niveau de redondance, la table de niveaux de redondance stockant une correspondance entre le niveau de redondance et le taux de redondance de données.

FIG. 1

FIG. 2

| | |
|---|---|
| Obtain a video bit rate and a redundant level sent by a receiving end, the video bit rate and the redundant level being determined according to a packet loss rate | — 310 |

| | |
|---|---|
| Obtain a data redundancy rate according to the redundant level | — 320 |

| | |
|---|---|
| Perform compression coding on original video data according to the video bit rate, to obtain compressed video data | — 330 |

| | |
|---|---|
| Allocate frame-level redundancy bit rate budgets for frames of the compressed video data according to the video bit rate and the data redundancy rate | — 340 |

| | |
|---|---|
| Packetize, according to the frame-level redundancy bit rate budgets, the frames of the compressed video data, and performing redundancy coding on the packetized frames of the compressed video data | — 350 |

FIG. 3

Count a packet loss rate of received video data — 410

Determine, according to the packet loss rate, a data redundancy rate for resisting the packet loss rate — 420

Perform bit rate allocation within an allowed bandwidth range, to acquire a security transmission bit rate — 430

Calculate a video bit rate according to the data redundancy rate and the security transmission bit rate — 440

Obtain a redundant level corresponding to the data redundancy rate — 450

Feed back the video bit rate and the redundancy level to a sending end, the video bit rate and the redundancy level being used by the sending end to perform redundancy control on the video data — 460

FIG. 4

Video data redundancy control apparatus

500

510
Receiving module

520
Obtaining module

530
Video coding module

540
Redundancy allocation module

550
Redundancy coding module

FIG. 5

Video data redundancy control apparatus

600

610
Counting module

620
Determining module

630
Acquisition module

640
Calculation module

650
Obtaining module

660
Sending module

FIG. 6

FIG. 7

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201610140656
- US 2015169396 A1
- EP 2713616 A1